# EUROPEAN PATENT APPLICATION

(11) **EP 4 358 687 A1**
(43) Date of publication of application: **24.04.2024**
(21) Application number: 23202286.3
(22) Date of filing: 07.10.2023
(51) Int. Cl.: H10N 70/00, G11C 11/56, H10N 70/20

(54) **ANALOG PROGRAMMABLE RESISTIVE MEMORY**

(30) Priority: 21.10.2022 US 202218048594
(71) Applicant: Cyberswarm, Inc, San Mateo, California 94401 (US)
(72) Inventor: DUMITRU, Viorel-Georgel, San Mateo, California, 94401 (US); IONESCU, Octavian-Narcis, San Mateo, California, 94401 (US)
(74) Representative: Morrall, Jonathan Ian McLachlan

(57) **Abstract**

One or more embodiments disclosed herein describe a nonvolatile, analog programmable resistive memory with a plurality of memory states. The programmable resistive memory includes a substrate, an IGZO resistive layer and electrical contacts. The electrical contacts are deposited on the IGZO layer, in the same plane. The electrical contacts may have various shapes in order to obtain spatially variable distances between the electrical contacts. The resistance of the resistive memory can be brought from an initial low value to a plurality of various higher values by applying electrical voltage pulses with various durations and various amplitudes and/or by applying one or more DC voltage sweeps. Also, the high voltage limit during the DC voltage sweeps could be set at values ranging from few volts to few tens of volts. In this manner, the IGZO programmable resistive memory could be set in a plurality of memory states.

## Description

### Cross-Reference To Related Applications

This application is based on and derives the benefit of the filing date of United States Patent Application No. 18/048,594, filed 21 October 2022.

### Background

Programmable resistive memories are devices that can store information as different resistance states. In many applications it is highly desirable to have an analog programmable resistive memory. Such memories have a resistance that could be modified in an analog manner. Analog programmable resistive memories can be used in many fields like non-volatile solid state memories, programmable logic, pattern recognition, neuromorphic computing, etc. For instance, analog programmable resistive memories could be employed for biologically inspired computing, as synapses in artificial neural networks implemented in hardware. In this case, the different synaptic weights are stored as different resistive states.

Because they are capable to both store and process information, these devices are highly attractive for realizing in-memory computing. In this way, it is avoided the memory wall problem of von Neumann computing architectures which separate memory and processing units.

IGZO is widely used for realization of transparent thin films transistors (TFTs). Therefore, IGZO based resistive memories are attractive as they would employ for fabrication the well-established technology platform and processes already developed for TFTs.

IGZO based programmable resistive memories with remarkable properties were already developed in both vertical and planar geometries.

Also, US Patent No. 1 0,902,914 B2 describes an IGZO based programmable resistor with multiple resistive states comprising an IGZO resistive layer and two electrical contacts deposited on the IGZO layer in a same plane.

However, conventional approaches do not allow a fine and precise tuning of the resistor memories.

### Summary

One or more embodiments disclosed herein describe a nonvolatile, analog programmable resistive memory with a plurality of memory states. The programmable resistive memory includes a substrate, an IGZO resistive layer and electrical contacts (e.g., two electrical contacts). The electrical contacts are deposited on the IGZO layer, in the same plane. The electrical contacts may have various shapes in order to obtain a variable distance (also referred to as variable distances or spatially variable distances) between the electrical contacts. The resistance of the resistive memory can be brought from an initial low value to a plurality of various higher values by applying electrical voltage pulses with various durations and various amplitudes and/or by applying one or more DC voltage sweeps. For instance, duration of the voltage pulses could be from few milliseconds to hundreds of seconds and the amplitude of the voltage pulses could be from few volts to few tens of volts. Also, the high voltage limit during the DC voltage sweeps could be set at values ranging from few volts to few tens of volts. In this manner, the IGZO programmable resistive memory could be set in a plurality of (e.g., a large number of) memory states.

The reading of the resistive memory is done by measuring the current flowing through resistor when biased at a low voltage (0.1-1V);

Employing the electrical contacts deposited on the IGZO layer in the same plane and having various shapes in order to obtain a variable distance between the electrical contacts increases the number of achievable memory states and the precision of programming the resistive memory in the desired states allowing the obtaining of an improved analog programmable memory.

The analog programmable memory could be partially reset (brought to a somewhat lower resistive state) by applying voltage pulses or voltage sweeps with opposite polarity than those used for setting in a higher resistive state.

### Brief description of the drawings

FIG. 1 illustrates an example analog programmable resistive memory structure in accordance with the principles disclosed herein;
FIG. 2 illustrates another example analog programmable resistive memory structure in accordance with the principles disclosed herein;
FIG. 3 illustrates another example analog programmable resistive memory structure in accordance with the principles disclosed herein;
FIG. 4 illustrates another example analog programmable resistive memory structure in accordance with the principles disclosed herein;
FIG. 5 illustrates another example analog programmable resistive memory structure in accordance with the principles disclosed herein;
FIG. 6 illustrates another example analog programmable resistive memory structure in accordance with the principles disclosed herein;
FIG.7 illustrates an example programming of an analog resistive memory employing a sequence of programing voltage pulses with increasing amplitudes in small (0.1V) steps in accordance with the principles disclosed herein;
FIG. 8 illustrates an example current read at a low voltage (0.1V) during the sequence of programing voltage pulses depicted in FIG. 7 in accordance with the principles disclosed herein;
FIG. 9 illustrates an example programming of an analog resistive memory employing a sequence of programing voltage pulses with increasing amplitudes in small (0.1V) steps in logarithmic scale in accordance with the principles disclosed herein
FIG. 10 illustrates an example programming of an analog resistive memory employing a sequence of programing voltage pulses with increasing amplitudes in 1V steps in accordance with the principles disclosed herein;
FIG. 11 illustrates an example programming of an analog resistive memory employing a sequence of DC voltage sweeps with various subsequent upper sweep limits in accordance with the principles disclosed herein; and
FIG. 12 illustrates an example reading of the analog resistive memory by measuring the currents flowing through the memory element after setting the resistor in different resistance states by applying the DC sweeps with various subsequent upper sweep limits illustrated in FIG. 11 in accordance with the principles disclosed herein.

### Detailed description

One or more embodiments disclosed herein provide an analog programmable resistive memory. The memory may be nonvolatile and may have multiple states that can be programmed in an analog manner.

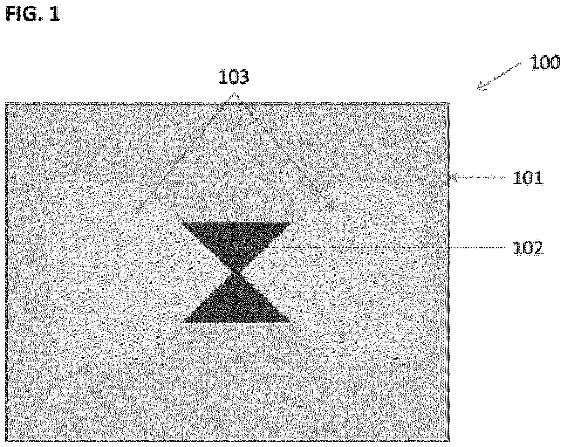

FIG. 1 illustrates an example analog programmable resistive memory 100 in accordance with the principles disclosed herein. The shown view is a top view. The programmable resistor memory 100 can include a substrate 101, a resistive layer 102, and electrical contacts 103. The substrate 101 can be formed from materials such as glass. The resistive layer 102 can be formed from an IGZO layer, for example. The electrical contacts 103 can be formed by Titanium (Ti)/Gold(Au), Aluminum (Al), Molybdenum (Mo), Palladium (Pd), Platinum (Pt) or any other metallization schema which is usually employed for the realization of electrical contacts of IGZO thin film transistors. As can be seen, the shape of the resistive layer 102 and the shapes of the electrical contacts 103 generate spatially variable distances between the electrical contacts 103.

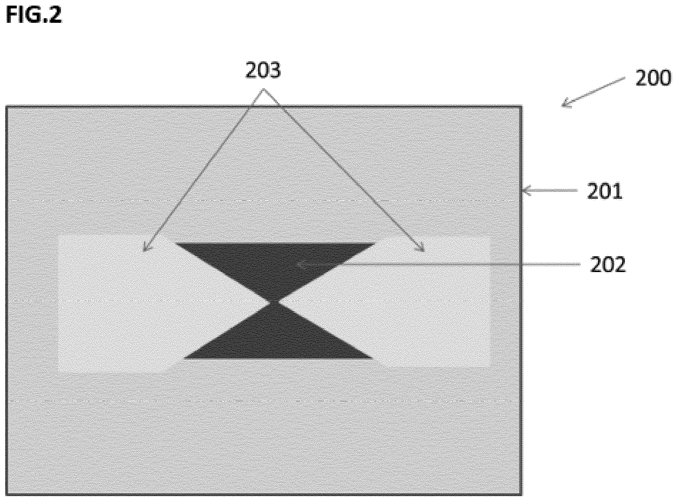

FIG. 2 illustrates another example analog programmable resistive memory 200 in accordance with the principles disclosed herein. The shown view is a top view. The programmable resistor memory 200 can include a substrate 201, a resistive layer 202 and electrical contacts 203. The substrate 201 can be formed from materials such as glass. The resistive layer 202 can be formed from an IGZO layer, for example. The electrical contacts 203 can be formed by Ti/Au, Al, Mo, Pd, Pt or any other metallization schema which is usually employed for the realization of electrical contacts of IGZO thin film transistors. As can be seen, the shape of the resistive layer 202 and the shapes of the electrical contacts 203 generate spatially variable distances between the electrical contacts 203.

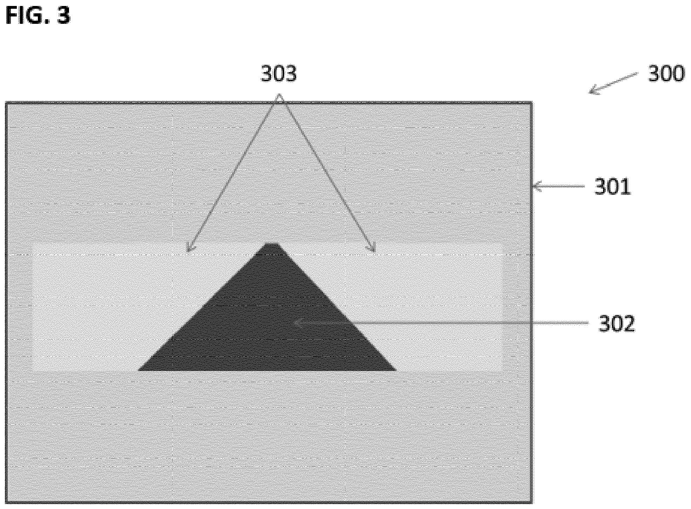

FIG. 3 illustrates another example analog programmable resistive memory 300 in accordance with the principles disclosed herein. The shown view is a top view. The programmable resistor memory 300 can include a substrate 301, a resistive layer 302 and electrical contacts 303. The substrate 301 can be formed from materials such as glass. The resistive layer 302 can be formed from an IGZO layer, for example. The electrical contacts 303 can be formed by Ti/Au, Al, Mo, Pd, Pt or any other metallization schema which is usually employed for the realization of electrical contacts of IGZO thin film transistors. As can be seen, the shape of the resistive layer 302 and the shapes of the electrical contacts 303 generate spatially variable distances between the electrical contacts 303.

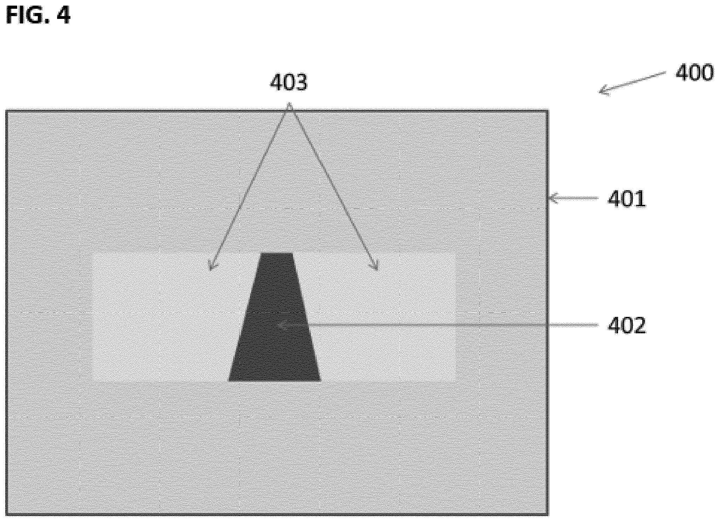

FIG. 4 illustrates another example analog programmable resistive memory 400 in accordance with the principles disclosed herein. The shown view is a top view. The programmable resistor memory 400 can include a substrate 401, a resistive layer 402 and electrical contacts 403. The substrate 401 can be formed from materials such as glass. The resistive layer 402 can be formed from an IGZO layer, for example. The electrical contacts 403 can be formed by Ti/Au, Al, Mo, Pd, Pt or any other metallization schema which is usually employed for the realization of electrical contacts of IGZO thin film transistors. As can be seen, the shape of the resistive layer 402 and the shapes of the electrical contacts 403 generate spatially variable distances between the electrical contacts 303.

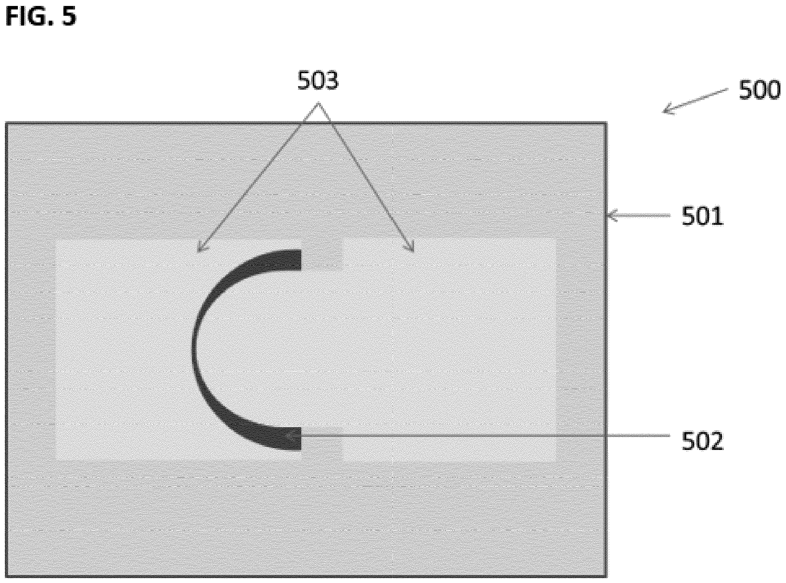

FIG. 5 illustrates another example analog programmable resistive memory 500 in accordance with the principles disclosed herein. The shown view is a top view. The programmable resistor memory 500 can include a substrate 501, a resistive layer 502 and electrical contacts 503. The substrate 501 can be formed from materials such as glass. The resistive layer 502 can be formed from an IGZO layer, for example. The electrical contacts 503 can be formed by Ti/Au, Al, Mo, Pd, Pt or any other metallization schema which is usually employed for the realization of electrical contacts of IGZO thin film transistors. As can be seen, the shape of the resistive layer 502 and the shapes of the electrical contacts 503 generate spatially variable distances between the electrical contacts 503.

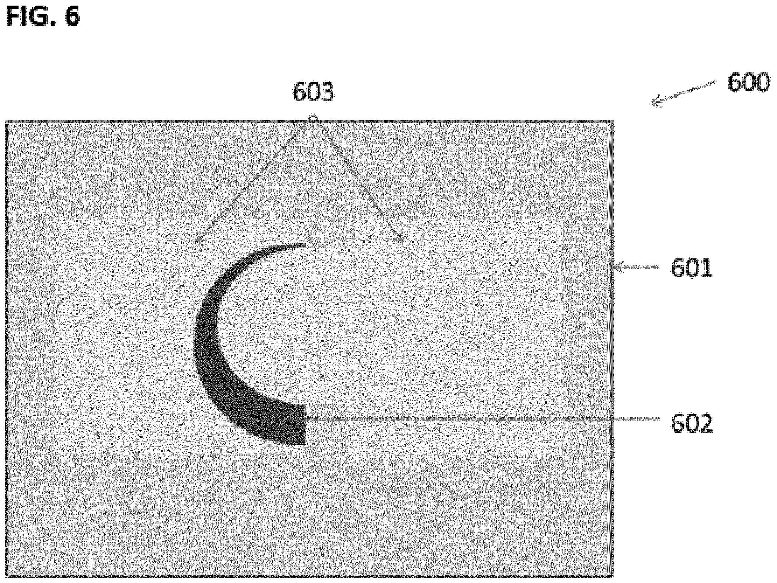

FIG. 6 illustrates another example analog programmable resistive memory 600 in accordance with the principles disclosed herein. The shown view is a top view. The programmable resistor memory 600 can include a substrate 601, a resistive layer 602 and electrical contacts 603. The substrate 601 can be formed from materials such as glass. The resistive layer 602 can be formed from an IGZO layer, for example. The electrical contacts 603 can be formed by Ti/Au, Al, Mo, Pd, Pt or any other metallization schema which is usually employed for the realization of electrical contacts of IGZO thin film transistors. As can be seen, the shape of the resistive layer 602 and the shapes of the electrical contacts 603 generate spatially variable distances between the electrical contacts 603.

The resistive memory elements depicted in FIG. 1 - FIG. 6 have two electrical contacts deposited on the IGZO layer in the same plane and having various shapes in order to obtain a variable distance (i.e., spatially variable distances, as described in the several embodiments above) between the two electrical contacts. However, it should be understood that these are just some examples, and many other different shapes of the electrical contacts could be employed in order to obtain a variable distance between the two electrical contacts.

For the fabrication of the resistive memory structures presented in FIG. 1 - FIG. 6, standard procedures employed for IGZO TFTs fabrication could be employed. The IGZO resistive layer could be deposited by sputtering in an Argon (Ar) atmosphere, for example. The electrical contacts could be realized by sputtering, electron-gun evaporation, thermal evaporation, or any other deposition method usually used in the field.

Usually, in the IGZO TFTs realization process, especially in case of IGZO obtained by sputtering in Ar atmosphere, after the fabrication, the device is subjected a high-temperature annealing step in air in order to increase the resistivity of the IGZO layer. For the realization of the IGZO programmable resistive memories this high-temperature annealing step can be omitted. Instead, the as-deposited, high conductivity IGZO resistors, are brought to higher resistance states by employing voltage pulses or voltage sweeps.

The voltage pulses could have various durations and various amplitudes, accordingly with the desired resistance state to be achieved. For instance, duration of the voltage pulses could be from few milliseconds to hundreds of seconds and the amplitude of the voltage pulses could be from few volts to few tens of volts. In order to set the resistive memory in a particular resistive state characterized by a specific resistance value, it is advantageous to apply a sequence of programing voltage pulses with increasing amplitudes. After applying one programing voltage pulse, it is advantageous to read the resistance of the resistive memory by measuring the current flowing through it when biased with a low voltage pulse (0.1V-1V) that is not affecting the resistive state of the resistive memory. If the difference between the read value of the resistive memory and the desired one is higher than a certain amount, the applying of the programing voltage pulses sequence is continuing one more step after which the resistance value of the resistive memory is read again. If the difference between the read value of the resistive memory and the desired one is lower than a certain amount, the applying of the programing voltage pulses sequence is stopped.

Employing two electrical contacts deposited on the IGZO layer in the same plane and having various shapes in order to obtain a variable distance between the two electrical contacts increases the number of achievable memory states and the precision of programming the resistive memory in the desired states allowing the obtaining of an improved analog programmable memory.

Once set in a certain higher resistive state, the analog programmable memory could be partially reset (bought to a somewhat lower resistive state) by applying voltage pulses or voltage sweeps with opposite polarity than those used for setting in a higher resistive state.

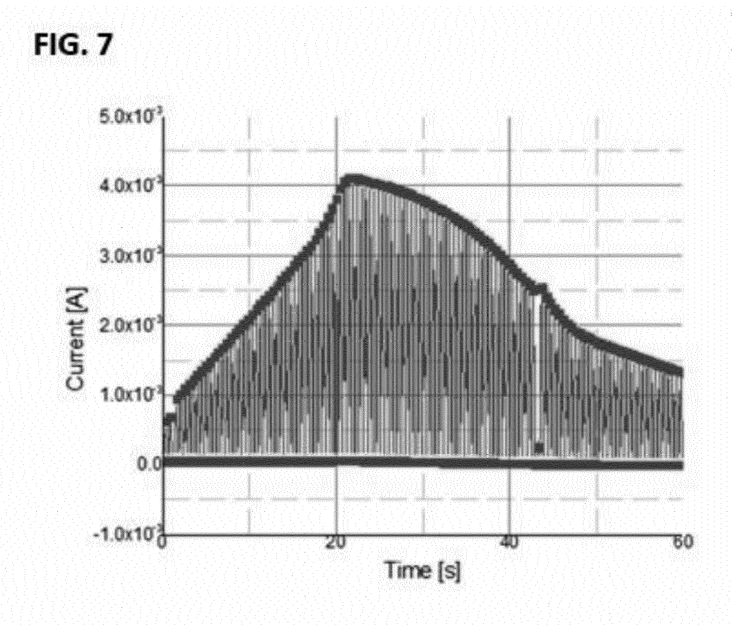

FIG. 7 shows an example programming of an analog resistive memory employing a sequence of programing voltage pulses with increasing amplitudes in small (0.1V) steps in accordance with the principles disclosed herein. After each programming voltage pulse, the analog programmable resistor is read by measuring the current flowing through resistor when biased at a low voltage (0.1 V);

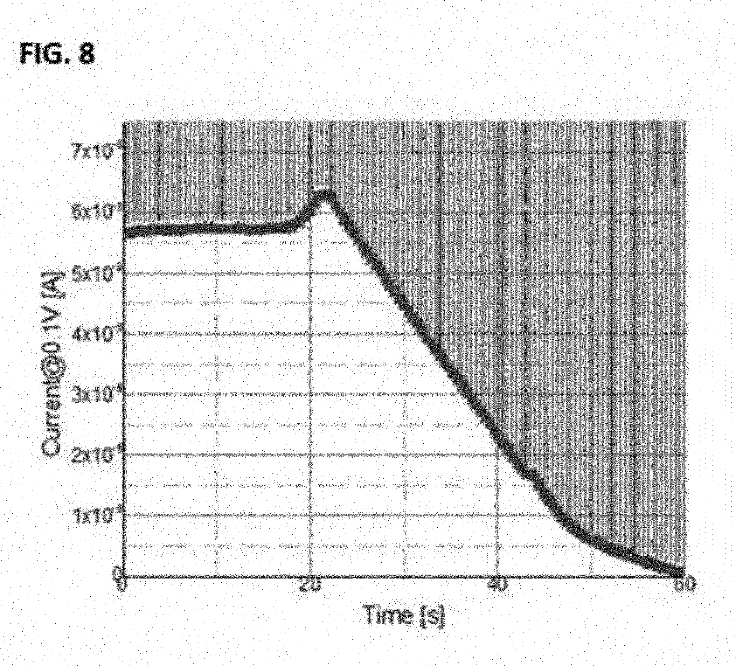

FIG. 8 illustrates an example current read at a low voltage (0.1V) during the sequence of programing voltage pulses depicted in FIG. 7 in accordance with the principles disclosed herein;

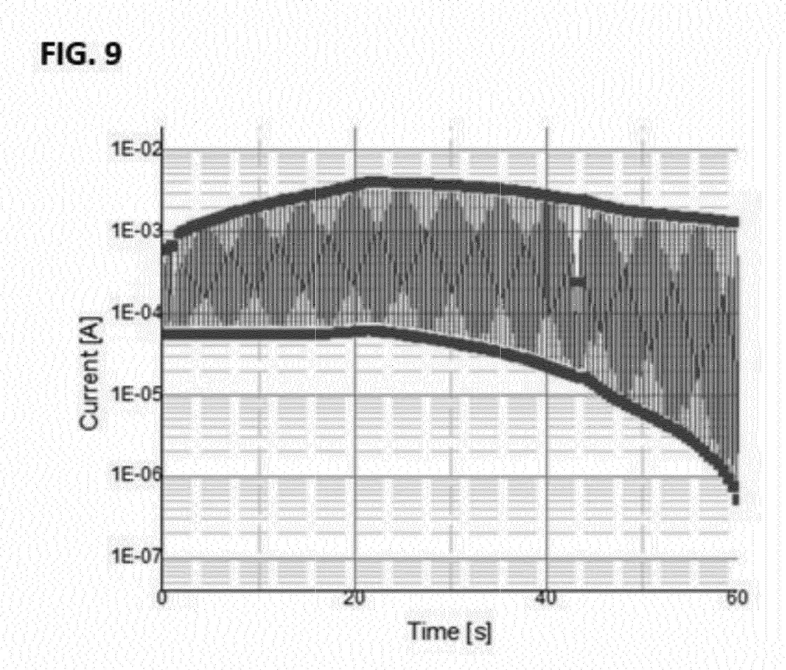

FIG. 9 illustrates an example programming of an analog resistive memory employing a sequence of programing voltage pulses with increasing amplitudes in small (0.1V) steps in logarithmic scale in accordance with the principles disclosed herein. After each programming voltage pulse, the analog programmable resistor is read by measuring the current flowing through resistor when biased at a low voltage (0.1 V);

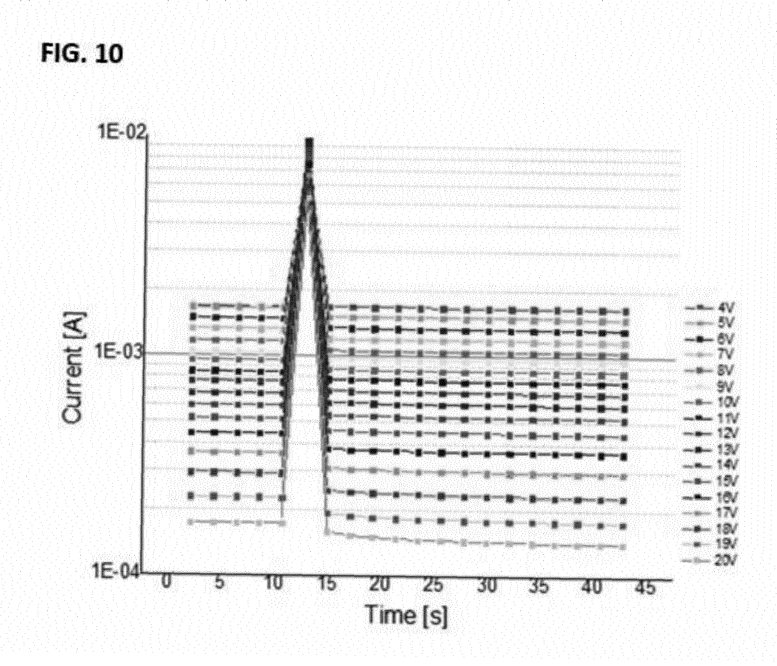

FIG. 10 illustrates an example programming of an analog resistive memory employing a sequence of programing voltage pulses with increasing amplitudes in 1V steps in accordance with the principles disclosed herein. Before and after applying the programming voltage pulse the analog programmable resistor is read by measuring the current flowing through resistor when biased at a low voltage (1 V);

Also, voltage sweeps could be employed for setting the as-deposited IGZO resistors in various higher resistance states. By setting the upper limit of the voltage sweeps and the number of sweeps cycles done with the respective upper voltage limit, different values of the resistance can be obtained. The high voltage limit during the sweeps could be set at values ranging from few volts to few tens of volts. In this manner, the number of memory states is greatly increased.

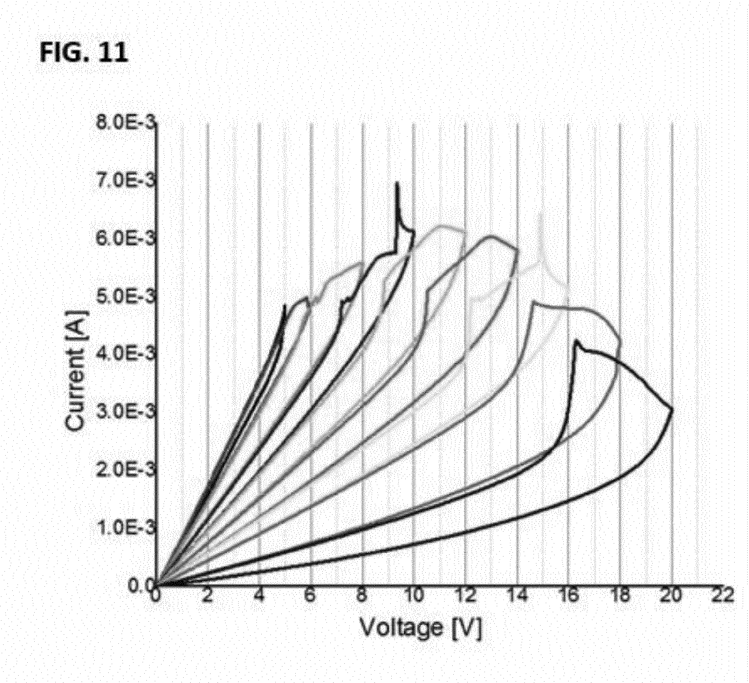

FIG. 11 illustrates an example programming of an analog resistive memory employing a sequence of DC voltage sweeps with various subsequent upper sweep limits in accordance with the principles disclosed herein.

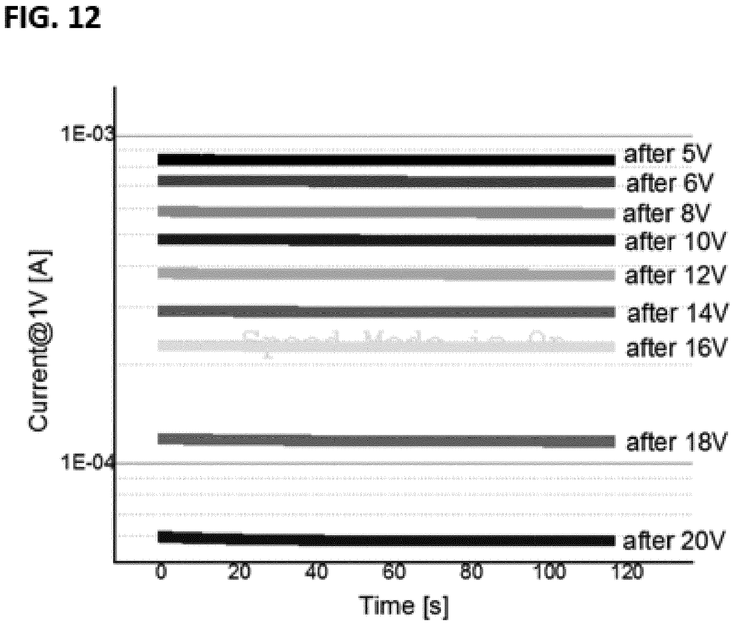

FIG. 12 illustrates an example reading of the analog resistive memory by measuring the currents flowing through the memory element after setting the resistor in different resistance states by applying the DC sweeps with various subsequent upper sweep limits illustrated in FIG. 11 in accordance with the principles disclosed herein.

Also disclosed herein are the following numbered clauses:
1. An analog programmable resistive memory with multiple memory states comprising:
   an Indium Gallium Zinc Oxide (IGZO) resistive layer; and
   two electrical contacts situated in a same plane and having preconfigured shapes in order to obtain spatially variable distances between the two electrical contacts.
2. The analog programmable resistive memory of clause 1, wherein the resistance of the resistive layer is configured by applying one or more voltage pulses.
3. The analog programmable resistive memory of clause 2, wherein the voltage pulses have durations from few milliseconds to hundreds of seconds and amplitudes from few volts to few tens of volts.
4. The analog programmable resistive memory of clause 1, wherein the resistance of the resistive layer is configured by applying a sequence of programing voltage pulses with increasing amplitudes.
5. The analog programmable resistive memory of clause 1, wherein the resistance of the resistive layer is configured by applying one or more voltage sweeps with a predetermined upper voltage limit.
6. The analog programmable resistive memory of clause 1 where the resistance of each memory state of the multiple memory states is configured to be monitored by measuring a current through the resistive memory biased with a low voltage pulse not affecting a resistive state of the resistive memory.
7. A method of fabricating an analog programmable resistive memory with multiple memory states, the method comprising:
   depositing an Indium Gallium Zinc Oxide (IGZO) resistive layer on a substrate; and
   depositing, on a same plane and on the substrate, two electrical contacts on a same plane and having particular shapes to have spatially variable distances between the two electrical contacts.
8. The method of clause 7, wherein depositing the IGZO resistive layer comprises:
   sputtering the IGZO resistive layer in an Argon (Ar) atmosphere.
9. The method of clause 7, wherein depositing the two electrical contacts comprises:
   performing the deposition of the two electrical contacts through at least one of sputtering, electron-gun evaporation, or thermal evaporation.
10. The method of clause 7, wherein the substrate is formed by glass.
11. The method of clause 7, wherein the two electrical contacts are formed by one or more of Titanium (Ti), Gold (Au), Aluminum (Al), Molybdenum (Mo), Palladium (Pd), or Platinum (Pt).
12 The method of clause 7, further comprising:
   programming the resistance of the resistive layer by applying one or more voltage pulses.
13. The method of clause 12, wherein the voltage pulses have durations from few milliseconds to hundreds of seconds and amplitudes from few volts to few tens of volts.
14. The method of clause 7, further comprising:
   programming the resistance of the resistive layer by applying a sequence of programing voltage pulses with increasing amplitudes.
15. The method of clause 7, further comprising:
   programming the resistance of the resistive layer by applying one or more voltage sweeps with a predetermined upper voltage limit.
16. The method of clause 7, further comprising:
   monitoring the resistance of each memory state of the multiple memory states by measuring a current through the resistive memory biased with a low voltage pulse not affective a resistive state of the resistive memory.
17. A method of reading from an analog programmable resistive memory, the method comprising:
   measuring a current flow through an Indium Gallium Zinc Oxide (IGZO) resistive layer of the resistive memory,
   the measurement being performed using two electrical contacts situated in a same plane and having preconfigured shapes to have spatially variable distances between the two electrical contacts.
18. The method of clause 17, wherein the current measurement indicates a resistance state of the resistive layer.
19. The method of clause 17, wherein the resistance state of the resistive layer is programmed by an application of a sequence of programming voltage pulses.
20. The method of clause 17, wherein measuring the current flow through the IGZO resistive layer comprises:
   biasing the IGZO resistive layer at a low voltage.

## Claims

1. An analog programmable resistive memory with multiple memory states comprising:
an Indium Gallium Zinc Oxide (IGZO) resistive layer; and
two electrical contacts situated in a same plane and having preconfigured shapes in order to obtain spatially variable distances between the two electrical contacts.

2. The analog programmable resistive memory of claim 1, wherein the resistance of the resistive layer is configured by applying one or more voltage pulses, and optionally wherein the voltage pulses have durations from few milliseconds to hundreds of seconds and amplitudes from few volts to few tens of volts.

3. The analog programmable resistive memory of claim 1, wherein the resistance of the resistive layer is configured by applying a sequence of programing voltage pulses with increasing amplitudes, or wherein the resistance of the resistive layer is configured by applying one or more voltage sweeps with a predetermined upper voltage limit.

4. The analog programmable resistive memory of any preceding claim where the resistance of each memory state of the multiple memory states is configured to be monitored by measuring a current through the resistive memory biased with a low voltage pulse not affecting a resistive state of the resistive memory.

5. A method of fabricating an analog programmable resistive memory with multiple memory states, the method comprising:
depositing an Indium Gallium Zinc Oxide (IGZO) resistive layer on a substrate; and
depositing, on a same plane and on the substrate, two electrical contacts on a same plane and having particular shapes to have spatially variable distances between the two electrical contacts.

6. The method of claim 5, wherein depositing the IGZO resistive layer comprises:
sputtering the IGZO resistive layer in an Argon (Ar) atmosphere.

7. The method of claim 5 or 6, wherein depositing the two electrical contacts comprises:
performing the deposition of the two electrical contacts through at least one of sputtering, electron-gun evaporation, or thermal evaporation.

8. The method of any of claims 5 to 7, wherein the substrate is formed by glass.

9. The method of any of claims 5 to 8, wherein the two electrical contacts are formed by one or more of Titanium (Ti), Gold (Au), Aluminum (Al), Molybdenum (Mo), Palladium (Pd), or Platinum (Pt).

10. The method of any of claims 5 to 9, further comprising:
programming the resistance of the resistive layer by applying one or more voltage pulses, and optionally wherein the voltage pulses have durations from few milliseconds to hundreds of seconds and amplitudes from few volts to few tens of volts.

11. The method of any of claims 5 to 9, further comprising:
programming the resistance of the resistive layer by applying a sequence of programing voltage pulses with increasing amplitudes; or
programming the resistance of the resistive layer by applying one or more voltage sweeps with a predetermined upper voltage limit.

12. The method of any of claims 5 to 11, further comprising:
monitoring the resistance of each memory state of the multiple memory states by measuring a current through the resistive memory biased with a low voltage pulse not affective a resistive state of the resistive memory.

13. A method of reading from an analog programmable resistive memory, the method comprising:
measuring a current flow through an Indium Gallium Zinc Oxide (IGZO) resistive layer of the resistive memory,
the measurement being performed using two electrical contacts situated in a same plane and having preconfigured shapes to have spatially variable distances between the two electrical contacts.

14. The method of claim 13, wherein the current measurement indicates a resistance state of the resistive layer, and optionally wherein the resistance state of the resistive layer is programmed by an application of a sequence of programming voltage pulses.

15. The method of claim 13 or 14, wherein measuring the current flow through the IGZO resistive layer comprises:
biasing the IGZO resistive layer at a low voltage.
